# EUROPÄISCHE PATENTANMELDUNG

(11) **EP 1 674 929 A1**
(43) Veröffentlichungstag der Anmeldung: **28.06.2006**
(21) Anmeldenummer: 05028164.1
(22) Anmeldetag: 22.12.2005
(51) Int. Cl.: G03F 7/023

(54) **Verfahren zur Herstellung einer Photoresistlösung**

(30) Priorität: 23.12.2004 DE 102004063416
(71) Anmelder: AZ Electronic Materials (Germany) GmbH, 65203 Wiesbaden (DE)
(72) Erfinder: Zahn, Wolfgang, Dr., 65346 Eltville (DE); Grottenmüller, Ralf, Dr., 65199 Wiesbaden (DE); Brauch-Fischer, Carina, 56412 Unterhausen (DE); Dresel, Andreas, Dr., 65510 Hünstetten (DE); Englert, Stefan, 60529 Frankfurt (DE); Blaha, Daniela, 55543 Bad Kreuznach (DE)
(74) Vertreter: Isenbruck, Günter

(57) **Zusammenfassung**

Die Erfindung betrifft ein Verfahren zur Herstellung einer lichtempfindlichen Photoresistlösung, dadurch gekennzeichnet, dass ein Novolakharz und ein Diazonaphthochinon-sulfochlorid in einem Lösemittel aus der Gruppe der Photoresistlösemittel gelöst werden, ein Anteil von 1 bis 70 Mol-% der phenolischen Hydroxygruppen des Novolakharzes mit dem Diazonaphthochinon-sulfochlorid in Gegenwart einer Base umgesetzt wird, das Reaktionsgemisch mit Wasser gewaschen und gegebenenfalls mit weiterem Photoresistlösemittel verdünnt wird.

## Beschreibung

Die Erfindung betrifft ein Verfahren zur Herstellung einer lichtempfindlichen Photoresistlösung, das ohne Isolierung von Zwischenstufen auskommt.

Der Photoresist wird durch Umsetzung eines Novolaks und einer diazofunktionellen Komponente direkt in dem in der endgültigen Resistformulierung enthaltenen Lösemittel mit anschließender Aufreinigung, jedoch ohne Ausfällung und Isolierung von Zwischenstufen, hergestellt.

Photoresists werden in lithographischen Prozessen eingesetzt, z.B. zur Herstellung mikroelektronischer Bauteile wie integrierter Schaltkreise und Computer-Chips. Das allgemein bekannte Verfahren zur Herstellung von integrierten Schaltkreisen besteht darin, beispielsweise einen Siliziumwafer mit einer dünnen Schicht eines lichtempfindlichen Photoresists zu beschichten. Der beschichtete Wafer wird dann gebacken, um das im Photoresist enthaltene Lösemittel zu verdampfen und die Resistschicht auf dem Substrat zu fixieren. Anschließend wird das beschichtete Substrat durch eine Photomaske einer Bestrahlung ausgesetzt, die eine Veränderung in der chemischen oder physikalischen Beschaffenheit der Resistschicht bewirkt. Als Strahlung wird Licht im infraroten Bereich, sichtbares Licht, UV-Licht, Röntgenstrahlung oder Elektronenstrahlung verwendet. Nach der Bestrahlung wird das beschichtete Substrat mit einer Entwicklerlösung behandelt. Für den Fall eines Positiv- Resists werden die der Strahlung ausgesetzten Bereiche der Resistschicht gelöst und entfernt. Handelt es sich um einen Negativ-Resist, so werden die nicht bestrahlten Bereiche der Resistschicht gelöst und entfernt, und die bestrahlten Bereiche bleiben zurück. Bei Positiv-Resists wird die Zunahme der Löslichkeit beim Belichten oft durch Umlagerungsreaktionen oder durch Abspalten von Schutzgruppen erreicht. Bei Negativ- Resists kann die Abnahme der Löslichkeit beim Belichten beispielsweise durch das Eintreten von Vernetzungsreaktionen erreicht werden. In den Bereichen, in denen die Resistschicht durch den Entwicklungsvorgang abgelöst wurde, wird die ungeschützte Oberfläche des Substrats freigelegt, die dann geätzt wird, z.B. mit einer Ätzlösung oder mit einer Plasmabehandlung. Die Bereiche der Oberfläche, auf denen die Resistschicht noch vorhanden ist, werden vom Ätzvorgang nicht angegriffen. Die restliche Resistschicht wird nun vom Substrat vollständig abgelöst (Stripping). Es bleibt eine Substratoberfläche zurück, auf der sich ein Ätzmuster befindet, das der beim Belichten verwendeten Photomaske entspricht.

Als Rohstoffe für positiv arbeitende Photoresiste, die besonders geeignet sind für die Belichtung bei Wellenlängen von 365 nm (i-Linie), 405 nm (h-Linie) und 436 nm (g-Linie) sind Novolak-Harze bekannt, die mit Diazonaphthochinon-Funktionen kombiniert werden. Mit diesen Systemen lassen sich Strukturen bis etwa 0,25 µm erzeugen.

So beschreibt beispielsweise JP 59084239 (Fuji) eine lichtempfindliche Zusammensetzung, deren wesentlicher Bestandteil ein Novolak-Harz ist, dessen phenolische OH-Gruppen teilweise mit Diazonaphthochinon-Gruppen verestert sind. Die Synthese des modifizierten Novolaks läuft auf die übliche Weise durch Umsetzung des Harzes mit einem Diazonaphthochinon-Sulfonsäurechlorid in einem organischen Lösemittelgemisch (Methylethylketon/DMF) mit Triethylamin als Hilfsbase und anschließendem Ausfällen des Produkts mit Wasser, Umkristallisieren und Trocknen ab.

JP-63 178 229 (Fuji Photo Film) beschreibt eine positive Photoresistformulierung, die aus einer Mischung eines alkalilöslichen Novolak-Harzes und einem zu über 90% mit 1,2-Naphthochinon-4 bzw. -5-Sulfonsäure veresterten Hexahydroxybenzophenon zusammengesetzt ist.

In JP-10 097 066 (Shin-Etsu) wird ein positiv arbeitender Photoresist beschrieben, bestehend aus einem mit Diazonaphthochinon modifizierten Novolak und einer niedermolekularen Komponente. Der modifizierte Novolak wird durch Verestern der OH-Gruppen eines Novolaks mit einem Molgewicht von 2.000-20.000 g/mol zu 2,5-27 mol-% mit 1,2-Diazonaphthochinonsulfonsäure-Gruppen hergestellt. Die niedermolekulare Komponente enthält 2 bis 20 Benzoleinheiten mit einem Verhältnis von phenolischen OH-Gruppen zu Benzoleinheiten von 0,5-2,5.

JP-11 228 528 beschreibt die Herstellung eines Diazonaphthochinon-Sulfonsäureesters durch Veresterung einer Polyhydroxyverbindung mit Diazonaphthochinon-4- oder Diazonaphthochinon-5-sulfonsäurechlorid in Gegenwart einer Base (z.B. Triethylamin) in einem Lösemittel, das sowohl Ester- wie auch Ethergruppen aufweist (z.B. Ethyl-ethoxypropionat). Als Vorteil solcher Lösemittel wird ein guter Umsatz, geringe Toxizität, wenig Nebenreaktionen und eine leichte Isolierung des Produkts genannt.

In EP 1153915 (Toyo Gosei) wird eine Veresterung von Polyhydroxy-Phenolverbindungen (z.B. Tetrahydroxybenzophenon) mit 1,2-Diazo-naphthochinon-sulfonsäurechlorid in organischem Lösemittel (z.B. Tetrahydrofuran) in Gegenwart einer Hilfsbase (z.B. Triethylamin) beschrieben. Nach Zugabe eines Amid-Lösemittels (z.B. N,N-Dimethylacetamid) wird das ausgefallene Ammoniumhydrochlorid abfiltriert und das Produkt in einem Überschuss Wasser ausgefällt und anschließend getrocknet.

In US-5 723 254 (Shipley) und US-5 529 880 (Shipley) wird eine positiv arbeitende Photoresist-Formulierung beschrieben, die aus einer Mischung verschiedener photoaktiver Komponenten besteht. Eine der Komponenten ist ein Veresterungsprodukt aus Diazonaphthochinon-sulfonsäurechlorid mit einem Phenolharz. Eine weitere Komponente ist ein Veresterungsprodukt von Diazonaphthochinon-sulfonsäurechlorid mit einem niedermolekularen Phenolderivat, das eine bis drei aromatische Gruppen und eine bis drei OH-Gruppen besitzt. Als dritte Komponente kann zusätzlich noch ein Veresterungsprodukt von Diazonaphthochinon-sulfonsäurechlorid mit einem relativ hochmolekularen mehrkernigen Phenol zugegeben werden.

Nach dem derzeitigen Stand der Technik werden auf Novolaken basierende Photoresistlösungen in einem mehrstufigen Verfahren hergestellt. Die unterschiedlichen Bestandteile, wie z.B. Novolak-Harz und photoaktive Komponente, werden getrennt hergestellt, als Feststoff isoliert, dann gereinigt und getrocknet. Vor allem das Ausfällen der photoaktiven Komponente, das meist in einem großen Überschuss von Wasser erfolgt, und die anschließende Trocknung des Materials sind volumen- und zeitaufwendige Prozessschritte. Die separat aufgearbeiteten Einzelkomponenten werden dann in geeigneten Mengenverhältnissen zusammen in einem gemeinsamen Lösemittel gelöst und so die für die Anwendung fertige lichtempfindliche Photoresistlösung zubereitet.

WO 99/15935 (Clariant) beschreibt eine Photoresist-Zusammensetzung, die ein alkalilösliches Polymer bzw. Harz beinhaltet, das phenolische OH Gruppen oder Carboxylgruppen besitzt, die mit einem Vinylether oder einem Dialkylcarbonat und Katalysator umgesetzt sind. Die Umsetzung läuft in einem aprotischen Lösemittel (z.B. 1-Methoxy-2-propylacetat) ab. Nach Zugabe eines Photosäuregenerators kann die so hergestellte Reaktionslösung des Polymers direkt als Photoresistlösung eingesetzt werden, ohne Isolierung des Polymers oder weitere Aufreinigung.

In US-5 919 597 (IBM, Shipley) wird ein Verfahren zur Herstellung eines Photoresists ohne Isolierung von Zwischenstufen in einem "Eintopfverfahren" in einem Photoresistlösemittel beschrieben.

Die beiden zuletzt genannten Schriften beschränken sich ausdrücklich auf so genannte "chemisch verstärkte" Systeme. Bei chemisch verstärkten Systemen werden phenolische OH-Gruppen eines Harzes bzw. Polymers, beispielsweise die OH-Gruppen von Poly(hydroxystyrol), mit säurelabilen Gruppen (z.B. Acetale und t-Butoxycarbonylester) blockiert, um die Alkalilöslichkeit zu verringern. Das auf diese Weise veränderte Polymer ist selbst nicht photoaktiv und muss daher mit einer photoaktiven Komponente versetzt werden, die beim Belichten eine starke Säure freisetzt, welche eine chemische Reaktion auslöst, die die phenolischen OH Gruppen des Polymers freisetzt. Das Polymer wird dadurch in den belichteten Bereichen alkalilöslich und kann dort entwickelt werden.

Der Erfindung lag die Aufgabe zugrunde, ein vereinfachtes Verfahren zur Herstellung lichtempfindlicher Photoresistlösungen auf Basis nicht chemisch verstärkter Novolake bereitzustellen, ohne dass die anwendungstechnischen Eigenschaften nachteilig beeinflusst werden.

Gegenstand der Erfindung ist ein Verfahren zur Herstellung einer lichtempfindlichen Photoresistlösung, dadurch gekennzeichnet, dass ein Novolakharz und ein Diazonaphthochinon-sulfochlorid in einem Lösemittel aus .der Gruppe der Photoresistlösemittel gelöst werden, ein Anteil von 1 bis 70 Mol % der phenolischen Hydroxygruppen des Novolakharzes mit dem Diazonaphthochinon-sulfochlorid in Gegenwart einer Base umgesetzt wird, das Reaktionsgemisch mit Wasser gewaschen und gegebenenfalls mit weiterem Photoresistlösemittel verdünnt wird.

Im Gegensatz zu den in WO 99/15935 und US-5 919 597 beschriebenen Systemen handelt es sich bei der vorliegenden Erfindung nicht um ein chemisch verstärktes System, sondern um eine direkte Verknüpfung der photoaktiven Gruppen mit dem Novolakharz. Die Änderung der Alkalilöslichkeit erfolgt unmittelbar durch die photochemische Reaktion und die damit verbundene Umwandlung einer Diazogruppe in eine Carbonsäurefunktion.

Die Umsetzung des Novolaks mit dem Diazonaphthochinon-sulfochlorid erfolgt direkt in dem in der endgültigen Resistformulierung verwendeten Lösemittel. Eine aufwendige Aufarbeitung des Reaktionsprodukts durch Ausfällen, Isolieren und langwieriges Trocknen ist nicht erforderlich. Bei der Reaktion entstehende, unerwünschte Nebenprodukte wie beispielsweise Ammoniumhydrochlorid, welches durch aminkatalysierte Kondensation der phenolischen OH-Gruppen des Novolaks mit dem Diazonaphthochinon-Sulfonsäurechlorid anfällt, können problemlos durch Wäsche mit Wasser entfernt werden.

Als Novolak-Harz kommen solche mit einem Molgewicht von mindestens 1.200 g/mol in Betracht, die durch allgemein bekannte sauer- oder auch metallionenkatalysierte Kondensationsreaktionen aus Phenolen und niederen Aldehyden oder Ketonen zugänglich sind. Als Phenole kommen beispielsweise Phenol, o-, m- oder p-Alkylphenole, wie Kresole (1-, 2-oder 3-Methylphenol), Xylenole (2,3-, 2,4-, 2,5-, 2,6-, 3,4-, 3,5- oder 3,6-Dimethylphenol), o-, m- oder p-Phenylphenol, Dialkylphenole, Trialkylphenole, mono-, di- oder Trialkoxyphenole, Brenzcatechin (1,2-Dihydroxybenzol), Resorcin (1,3-Dihydroxybenzol), Hydrochinon (1,4-Dihydroxybenzol), Pyrogallol (1,2,3-Trihydroxybenzol), 1,2,4-Trihydroxybenzol oder Phloroglucin (1,3,5-Trihydroxybenzol) in Betracht. Diese oder andere Phenole können allein oder in Mischungen aus zwei oder mehreren Komponenten verwendet werden.

Als Aldehyd oder Keton, die einzeln oder in Kombination eingesetzt werden können, kommen beispielsweise Formaldehyd, Paraformaldehyd, Trioxan, Acetaldehyd, Benzaldehyd, Furfural, Propionaldehyd, Acrolein, Crotonaldehyd, Cyclohexylaldehyd, Aceton, Methylethylketon, Diethylketon, Diphenylketon in Betracht.

Ein aufgrund chemischer und physikalischer Eigenschaften geeignet ausgewähltes Novolak-Harz wird erfindungsgemäß modifiziert, indem ein Anteil von 1 bis 70 Mol %, vorzugsweise 1,5 bis 35 Mol %, insbesondere 2 bis 25 Mol %, der phenolischen Hydroxylgruppen mit einem Diazonaphthochinon-sulfochlorid umgesetzt wird, vorzugsweise mit 2,1-Diazonaphthochinon-4-sulfonsäurechlorid, 2,1-Diazonaphthochinon-5-sulfonsäurechlorid, 1,2-Diazonaphthochinon-6-sulfonsäurechlorid, 1,2-Diazonaphthochinon-7-sulfonsäurechlorid, 1,2-Diazonaphthochinon-8-sulfonsäurechlorid, 7-Methoxy-2,1-Diazonaphthochinon-5-sulfonsäurechlorid oder 7-Methoxy-2,1-Diazonaphthochinon-4-sulfonsäurechlorid. Die Synthesewege dieser Verbindungen sind hinlänglich bekannt und beschrieben (siehe z.B.: US-6 274 714 (Toyo Gosei) und J.Bendig, E.Sauer, K.Polz, G.Schopf, "Synthesis and photochemistry of 1,2-naphthoquinonediazide-(2)-n-sulfonic acid derivatives", Tetrahedron, 48 (42), 1992, S. 9207-9216).

Die Umsetzung des Novolaks mit dem Diazonaphthochinon-sulfonsäurechlorid läuft in einem Lösemittel ab, das auch in der endgültigen Photoresist-Formulierung beibehalten wird.

Photoresistlösemittel sind beispielsweise PGME (1,2-Propylenglykol-monomethylether), PGMEA (1-Methoxy-2-propylacetat), Ethyllactat (Milchsäureethylester), Butoxyl (3-Methoxy-butylacetat), PnB (1-Butoxy-2-propylacetat), Ethylacetat, Butylacetat, MEK (2-Butanon), 2-oder 3-Pentanon, MIPK (3-Methyl-2-butanon), MIBK (4-Methyl-2-pentanon), MAK (2-Heptanon), Methyl-Cellosolve (2-Methoxy-ethanol), Ethyl-Cellosolve (2-Ethoxy-ethanol), Methyl-Cellosolveacetat (Essigsäure-2-methoxyehtylester), Ethyl-Cellosolveacetat (Essigsäure-2-ethoxyethylester), γ-Butyrolacton, THF (Tetrahydrofuran), Tetrahydropyran, Dioxan und Cyclohexanon oder eine Kombination davon.

Bevorzugt als Photoresistlösemittel sind 1-Methoxy-2-propylacetat, 3-Methoxy-butylacetat, 1-Butoxy-2-propylacetat, Ethylacetat, Butylacetat, 2- oder 3-Pentanon, 3-Methyl-2-butanon, 4-Methyl-2-pentanon, 2-Heptanon und Cyclohexanon oder eine Kombination davon. Besonders bevorzugt sind 1-Methoxy-2-propylacetat, 3-Methoxy-butylacetat, 1-Butoxy-2-propylacetat, Butylacetat und 2-Heptanon oder eine Kombination davon.

Die Umsetzung der phenolischen OH-Gruppen des Novolaks mit dem Sulfonsäurechlorid erfordert die Gegenwart einer Base, um frei werdendes HCl abzufangen. Bevorzugt werden tertiäre Amine, wie beispielsweise Triethylamin, Pyridin, N-Alkylmorpholin oder Triethanolamin. Es sind jedoch prinzipiell auch andere basische Komponenten möglich, darunter z.B. wässriger Ammoniak, anorganische Hydroxyde oder Carbonate oder feste, im verwendeten Lösemittel unlösliche Basen wie z.B. basische Ionentauscher.

Die erfindungsgemäße Umsetzung wird vorzugsweise bei Temperaturen zwischen -10°C und +60°C, bevorzugt bei +10°C bis +40°C, durchgeführt. Höhere Temperaturen sind aufgrund der thermischen Instabilität der Diazogruppen ungeeignet.

Die Menge des Diazonaphthochinon-sulfonsäurechlorids wird dabei so bemessen, dass der erfindungsgemäße Umsetzungsgrad der Hydroxygruppen des Novolaks erreicht wird.
Die Menge der Base ist zweckmäßigerweise mindestens molar äquivalent zum Sulfonsäurechlorid zu wählen. Um die Reaktion zu beschleunigen und/oder einen vollständigen Umsatz sicherzustellen, kann die Base auch im Überschuss eingesetzt werden.

Die Menge des Photoresistlösemittels ist so gewählt, dass die Reaktionslösung gut handhabbar und rührbar bleibt, d.h. dass die Viskosität der Reaktionslösung nicht zu hoch wird und alle Edukte vollständig gelöst sind. Vorzugsweise wird mit einem Lösemittelgehalt der Reaktionsmischung von 55 bis 90 Gew.-% gearbeitet.

Nach vollständiger Umsetzung der Reaktionskomponenten wird, in dem Fall dass ein tertiäres Amin als Base eingesetzt wurde, entstandenes Ammoniumhydrochlorid entfernt. Das kann durch Abfiltrieren von ausgefallenem Salz bzw. durch Auswaschen mit Wasser erfolgen. Das Salz löst sich nahezu vollständig in der wässrigen Phase und kann durch Phasentrennung entfernt werden.
Bei Bedarf kann das Auswaschen mit Wasser wiederholt werden. Alternativ kann zum Entfernen von ionischen Verunreinigungen auch eine Behandlung mit Ionentauscher durchgeführt werden.
Meist besitzt das Photoresistlösemittel eine gewisse Löslichkeit für Wasser, so dass nach dem Auswaschen eine gewisse Menge Wasser homogen in der organischen Phase gelöst zurückbleibt. Falls die Menge an gelöstem Wasser für die Endanwendung zu hoch ist, kann das Wasser problemlos durch Destillation entfernt werden. Vorzugsweise wird unter vermindertem Druck destilliert, um die thermische Belastung der Reaktionslösung so gering wie möglich zu halten. Die Destillation kann batchweise aus einem Kolben bzw. Kessel oder auch kontinuierlich mit Hilfe eines Dünnschichtverdampfers erfolgen. Sollte die Konzentration der erhaltenen Resistlösung nicht den Erfordernissen entsprechen, kann entweder mit demselben oder einem anderen Photoresistlösemittel verdünnt werden oder durch Destillation, Membranfiltration oder andere geeignete Maßnahmen aufkonzentriert werden.

Bei Bedarf können der erfindungsgemäß umgesetzten Lösung noch weitere Komponenten zugesetzt werden, um beispielsweise die Lichtempfindlichkeit, den Dunkelabtrag, die Absorption, die Beschichtungseigenschaften, das Auflösungsvermögen oder sonstige Eigenschaften der Resistlösung zu verändern. Mögliche weitere Komponenten sind z.B. niedermolekulare mehrkernige Phenolderivate wie z.B. Polyhydroxy-Benzophenone oder Novolak-Oligomere mit 2 bis 5 aromatischen Einheiten, deren phenolische OH Gruppen frei sind oder ebenfalls mit diazofunktionellen Verbindung umgesetzt sind. An Polyhydroxy-Benzophenonen kommen beispielsweise 4,4'-Dihydroxy-benzophenon, 2,4-Dihydroxy-benzophenon, 2,4,4'-Trihydroxy-benzophenon und 2,3,4,4'-Tetrahydroxy-benzophenon in Frage und an Novolak-Oligomeren beispielsweise 4,4'-Ethylenbis-phenol, 2,2'-Methylenbis[4-methylphenol], 4,4',4''-Methylidentris-phenol, 2,6-Bis[(2-hydroxy-5-methylphenyl)methyl]-4-methyl-phenol, 2,2'-[(4-Hydroxyphenyl)methylen]bis(3,5-dimethyl-phenol), 2,2'-Methylenbis[6-[(2-hydroxy-5-methylphenyl)methyl]-4-methyl-phenol] und 4,4'-[1-[4-[1-(4-Hydroxy-3,5-dimethylphenyl)-1-methylethyl]-phenyl]ethyliden]bis(2,6-dimethyl-phenol). Darüber hinaus ist die Zugabe von weiteren Novolaken möglich.

Die so hergestellte Photoresistlösung wird zur Herstellung von integrierten Halbleiterschaltelementen, Fotofiltern und FPDs, wie Flüssigkristallbildschirmen, auf ein Substrat aufgebracht. Die Substrate können beliebige Substrate mit einer beliebigen Größe, wie Glassubstrate und Siliziumsubstrate, sein. Es können auch solche Substrate sein, die einen Film, zum Beispiel einen Chromfilm, einen Siliziumoxidfilm oder einen Antireflexionsfilm enthalten. Das Substrat kann mit der Resistlösung nach jedem bekannten Verfahren beschichtet werden, beispielsweise durch Aufschleudern (Spin Coating), Rollen (Roll Coating), Land Coating, Fließbeschichtung (Flow and Spread Coating), Rakeln (Docter Coating), Tauchen (Dip Coating) und die Schlitzbeschichtung (Slit Coating).

Die Photoresistlösung wird auf das Substrat aufgetragen und dann vorgebacken, um einen lichtempfindlichen Film zu bilden, Danach wird der Film nach Verfahren, die bekannt und dem Fachmann geläufig sind, durch eine Photomaske belichtet und entwickelt, um ein Resistmuster zu bilden. Bevorzugt ist dabei Licht der Wellenlänge 365 nm, 405 nm und 436 nm.

Der Entwickler, der zur anschließenden Entwicklung angewendet wird, kann ein beliebiger Entwickler sein, wie er in gewöhnlichen lichtempfindlichen Harzzusammensetzungen verwendet wird. Bevorzugte Beispiele des Entwicklers beinhalten basische Entwickler, d. h. wässrige Lösungen von alkalischen Verbindungen, wie Tetraalkylammoniumhydroxid, Cholin, Alkalimetallhydroxiden, Alkalimetallmetasilikaten (Hydrate), Alkalimetallphosphaten (Hydrate), Ammoniaklösung, Alkylaminen, Alkanolaminen und heterozyklischen Aminen; eine wässrige Lösung von Tetramethylammoniumhydroxid ist als alkalischer Entwickler besonders bevorzugt. Gegebenenfalls können die alkalischen Entwicklerlösungen wasserlösliche organische Lösungsmittel, wie Methanol und Ethanol, oder Tenisde enthalten. Nach Entwicklung mit dem alkalischen Entwickler wird gewöhnlich mit Wasser gewaschen.

Gegenstand der Erfindung ist weiterhin ein Verfahren zur strukturierten Beschichtung eines Substrats, wobei
a) ein Novolakharz und ein Diazonaphthochinon-sulfochlorid in einem Lösemittel aus der Gruppe der Photoresistlösemittel gelöst werden, ein Anteil von 1 bis 70 Mol-% der phenolischen Hydroxygruppen des Novolakharzes mit dem Diazonaphthochinon-sulfochlorid in Gegenwart einer Base umgesetzt wird, das Reaktionsgemisch mit Wasser gewaschen und gegebenenfalls mit weiterem Photoresistlösemittel verdünnt wird,
b) die so erhaltene Photoresistlösung direkt auf ein Substrat aufgebracht und vorgebacken wird,
c) der gebildete Photoresistfilm durch eine Photomaske belichtet wird,
d) der belichtete Photoresistfilm gebacken wird und
e) der gebackene, belichtete Photoresistfilm mit einem alkalischen Entwickler entwickelt wird.

Die Synthese wird im Folgenden an mehreren Beispielen veranschaulicht, ohne dadurch eingeschränkt zu werden, wobei die Beispiele 1 bis 3 nach dem erfindungsgemäßen Verfahren durchgeführt werden und die Vergleichsbeispiele 1 bis 3 nach dem herkömmlichen Verfahren unter Isolierung der Zwischenprodukte.

### Beispiel 1

900 g eines Novolaks (40:60 m-Kresol/p-Kresol, mittleres Molgewicht 4000 g/mol gemessen mit GPC gegen Polystyrolstandard) und 60,8 g 2,1-Diazonaphthochinon-5-sulfonsäurechlorid werden in 3750 g PGMEA klar gelöst. Bei einer Temperatur von 20°C werden 40 g Triethanolamin zugegeben und 60 min gerührt. Die Lösung wird nun mit 1700 g 0,3 gew.-%iger wässriger HCl gewaschen. Nach Abtrennen der wässrigen Phase wird die PGMEA-Phase mit 1700 g entionisiertem Wasser gewaschen und die wässrige Phase abgetrennt. Die organische Phase wird zunächst bei 45°C und einem Vakuum von 20 mbar für 60 min andestilliert. Es destilliert ein Gemisch von Wasser und PGMEA ab. Das Vakuum wird dann auf einen Druck von 8 mbar geändert und weitere ca. 60 min destilliert, wobei fast reines PGMEA abdestilliert wird. Es verbleiben 2714 g einer 35 gew.-%igen Lösung des Diazonaphthochinonfunktionalisierten Novolaks in PGMEA mit einem Wassergehalt von < 0,2 % und einem Chloridionengehalt von < 20 ppm. Der durchschnittliche Veresterungsgrad beträgt 3 Mol-%, d.h. dass von 100 phenolischen Monomereinheiten des Novolaks im Mittel 3 Monomereinheiten verestert sind.

### Beispiel 2

900 g eines Novolaks (40:60 m-Kresol/p-Kresol, mittleres Molgewicht 4000 g/mol gemessen mit GPC gegen Polystyrolstandard) und 101,3 g 2,1-Diazonaphthochinon-5-sulfonsäurechlorid werden in 3750 g PGMEA klar gelöst. Bei einer Temperatur von 20°C werden 67 g Triethanolamin zugegeben und 60 min gerührt. Die Lösung wird nun mit 1700 g 0,4 gew.-%iger wässriger HCl gewaschen. Nach Abtrennen der wässrigen Phase wird die PGMEA-Phase mit 1700 g entionisiertem Wasser gewaschen und die wässrige Phase abgetrennt. Die organische Phase wird zunächst bei 45°C und einem Vakuum von 20 mbar für 60 min andestilliert. Es destilliert ein Gemisch von Wasser und PGMEA ab. Das Vakuum wird dann auf einen Druck von 8 mbar geändert und weitere ca. 60 min destilliert, wobei fast reines PGMEA abdestilliert wird. Es verbleiben 2800 g einer 35 gew.-%igen Lösung des Diazonaphthochinonfunktionalisierten Novolaks in PGMEA mit einem Wassergehalt von < 0,2 % und einem Chloridionengehalt von < 20 ppm. Der mittlere Veresterungsgrad beträgt 5 Mol-%.

### Beispiel 3

900 g eines Novolaks (m-Kresol/2,5-Xylenol, mittleres Molgewicht 2500 g/mol gemessen mit GPC gegen Polystyrolstandard) und 200,1 g 2,1-Diazonaphthochinon-5-sulfonsäurechlorid werden in 3750 g PGMEA klar gelöst. Bei einer Temperatur von 20°C werden 131,5 g Triethanolamin zugegeben und 60 min gerührt. Die Lösung wird nun mit 1700 g 0,8 gew.-%iger wässriger HCl gewaschen. Nach Abtrennen der wässrigen Phase wird die PGMEA-Phase mit 1700 g entionisiertem Wasser gewaschen und die wässrige Phase abgetrennt. Die organische Phase wird zunächst bei 45°C und einem Vakuum von 20 mbar für 60 min andestilliert. Es destilliert ein Gemisch von Wasser und PGMEA ab. Das Vakuum wird dann auf einen Druck von 8 mbar geändert und weitere ca. 60 min destilliert, wobei fast reines PGMEA abdestilliert wird. Es verbleiben 2995 g einer 35 gew.-%igen Lösung des Diazonaphthochinonfunktionalisierten Novolaks in PGMEA mit einem Wassergehalt von < 0,2 % und einem Chloridionengehalt von < 20 ppm. Der mittlere Veresterungsgrad beträgt 10 Mol-%.

### Vergleichsbeispiel 1

### (gleiche Komponenten wie in Beispiel 1, jedoch mit Isolieren der Zwischenstufe)

900 g eines Novolaks (40:60 m-Kresol/p-Kresol, mittleres Molgewicht 4000 g/mol gemessen mit GPC gegen Polystyrolstandard) und 60,8 g 2,1-Diazonaphthochinon-5-sulfonsäurechlorid werden in 3000 g Aceton klar gelöst. Bei einer Temperatur von 15 bis 20°C werden innerhalb von 30 min 25 g Triethylamin zugetropft und 60 min nachgerührt. Die Lösung wird von ausgefallenem Ammoniumhydrochlorid abfiltriert und langsam in 20 kg 0,1 gew.-%ige wässrige HCl getropft. Das ausgefallene Produkt wird abgesaugt, mit 2 kg entionisiertem Wasser gewaschen, in 2500 g Aceton gelöst und durch Zutropfen in 10 kg entionisiertes Wasser erneut ausgefällt. Nach Waschen mit 2 kg entionisiertem Wasser wird das Produkt trockengesaugt und bei 40°C für 72 h getrocknet. Man erhält 880 g eines rot-braunen Feststoffs mit einem Wassergehalt von < 0,2 % und einem Chloridionengehalt von < 20 ppm. Der mittlere Veresterungsgrad beträgt 3 Mol-%. Für die weitere Verarbeitung werden 350 g des Produkts in 650 g PGMEA zu einer 35 gew.-%igen Einstellung klar gelöst.

### Vergleichsbeispiel 2

### (gleiche Komponenten wie in Beispiel 2, jedoch mit Isolieren der Zwischenstufe)

900 g eines Novolaks (40:60 m-Kresol/p-Kresol, mittleres Molgewicht 4000 g/mol gemessen mit GPC gegen Polystyrolstandard) und 101,3 g 2,1-Diazonaphthochinon-5-sulfonsäurechlorid werden in 3000g Aceton klar gelöst. Bei einer Temperatur von 15 bis 20°C werden innerhalb von 30 min 42 g Triethylamin zugetropft und 60 min nachgerührt. Die Lösung wird von ausgefallenem Ammoniumhydrochlorid abfiltriert und langsam in 20 kg 0,12 gew.-%ige wässrige HCl getropft. Das ausgefallene Produkt wird abgesaugt, mit 2 kg entionisiertem Wasser gewaschen, in 2500 g Aceton gelöst und durch Zutropfen in 10 kg entionisiertes Wasser erneut ausgefällt. Nach Waschen mit 2 kg entionisiertem Wasser wird das Produkt trockengesaugt und bei 40°C für 72 h getrocknet. Man erhält 932 g eines rot-braunen Feststoffs mit einem Wassergehalt von < 0,2 % und einem Chloridionengehalt von < 20 ppm. Der mittlere Veresterungsgrad beträgt 5 Mol-%. Für die weitere Verarbeitung werden 350 g des Produkts in 650 g PGMEA zu einer 35 gew.-%igen Einstellung klar gelöst.

### Vergleichsbeispiel 3

### (gleiche Komponenten wie in Beispiel 3, jedoch mit Isolieren der Zwischenstufe)

900 g eines Novolaks (m-Kresol/2,5-Xylenol, mittleres Molgewicht 2500 g/mol gemessen mit GPC gegen Polystyrolstandard) und 200,1 g 2,1-Diazonaphthochinon-5-sulfonsäurechlorid werden in 3000 g Aceton klar gelöst. Bei einer Temperatur von 15 bis 20°C werden innerhalb von 30 min 82,5 g Triethylamin zugetropft und 60 min nachgerührt. Die Lösung wird von ausgefallenem Ammoniumhydrochlorid abfiltriert und langsam in 20 kg 0,14 gew.-%ige wässrige HCl getropft. Das ausgefallene Produkt wird abgesaugt, mit 2 kg entionisiertem Wasser gewaschen, in 2500 g Aceton gelöst und durch Zutropfen in 10 kg entionisiertes Wasser erneut ausgefällt. Nach Waschen mit 2 kg entionisiertem Wasser wird das Produkt trockengesaugt und bei 40°C für 72 h getrocknet. Man erhält 985 g eines rot-braunen Feststoffs mit einem Wassergehalt von < 0,2 % und einem Chloridionengehalt von < 20 ppm. Der mittlere Veresterungsgrad beträgt 10 Mol-%. Für die weitere Verarbeitung werden 350 g des Produkts in 650g PGMEA zu einer 35 gew.-%igen Einstellung klar gelöst.

Die in den Beispielen 1 bis 3 und den Vergleichsbeispielen 1 bis 3 hergestellten Lösungen werden mit PGMEA auf einen Feststoffgehalt von insgesamt 27 Gew.-% verdünnt und gegebenenfalls mit weiteren, in der nachfolgenden Tabelle angegebenen Zusatzstoffen versetzt, wobei gebrauchsfertige Resistlösungen entstehen.

| | Produkt aus: ¹⁾ | | | | | |
|---|---|---|---|---|---|---|
| Resist | Beispiel | Vergleichsbeispiel | PAC ²⁾ | PGMEA | Additiv ³⁾ | FS ⁴⁾ |
| Nr.1 | 1 | -- | 3 g | 33 g | 0,015 g | 27% |
| Nr.2 | -- | 1 | 3 g | 33 g | 0,015 g | 27% |
| Nr.3 | 2 | -- | -- | 25 g | 0,015 g | 27% |
| Nr.4 | -- | 2 | -- | 25 g | 0,015 g | 27% |
| Nr.5 | 3 | -- | -- | 25 g | 0,015 g | 27% |
| Nr.6 | -- | 3 | -- | 25 g | 0,015 g | 27% |

| | | | | | | |
|---|---|---|---|---|---|---|
| ¹⁾ jeweils 86 g der 35 %igen Lösung | | | | | | |
| ²⁾ zu 85 Mol-% mit 2,1-Diazonaphthochinon-5-sulfonsäurechlorid verestertes 2,3,4-Trishydroxybenzophenon | | | | | | |
| ³⁾ KP 341: Netzmittel | | | | | | |
| ⁴⁾ Feststoffgehalt der Einstellung in Gewichtsprozent | | | | | | |

Bei lithographischen Prüfungen sind zwischen den direkt in Lösung synthetisierten Produkten und den als Feststoff isolierten und nachträglich gelösten Produkten keine Eigenschaftsunterschiede zu erkennen.

### Der Lithographieprozess wird wie folgt durchgeführt:

Die Beschichtung der Lösung erfolgt auf Si-Wafer mit Schleuderbeschichtung (spin coating), wobei die Drehzahl so eingestellt wird, dass eine Zielschichtdicke von 1,2 µm nach dem Trocknen der Schicht erreicht wird. Nach der Beschichtung wird der Wafer auf einer regelbaren Heizplatte (hotplate) unter definierten Bedingungen zum Entfernen des Lösemittels gebacken. Im Allgemeinen wird bei einer Temperatur von 90°C für 60 s getrocknet. Anschließend wird die Schicht mit einem Stepper mit unterschiedlichen Belichtungsdosen belichtet, wobei die Belichtungen so abgestimmt werden, dass Unter- und Überbelichtungen erfolgen, d.h. Maskenstrukturen werden mit Dimensionen, die größer als das Nominalmaß sind, bis zu Dimensionen, die kleiner als das Nominalmaß sind, abgebildet. Nach der Belichtung wird der Wafer auf der Heizplatte bei 110°C für 60 s gebacken. Danach wird die Schicht mit einer wässrigen, 2,38 gew.-%igen Tetramethylammoniumhydroxid-Lösung für 60 s bei 23°C entwickelt und anschließend wird der Wafer mit DI-Wasser gespült. Bei der Entwicklung werden die vorher belichteten Bereiche weggelöst.

Die Ergebnisse sind in der folgenden Tabelle zusammengefasst:

| Resist | DTP [mJ/cm²] | Dunkelabtrag [nm/min] |
|---|---|---|
| Nr.1 | 39 | 49 |
| Nr.2 | 33 | 73 |
| Nr.3 | 63 | 7 |
| Nr.4 | 65 | 9 |
| Nr.5 | 29 | 46 |
| Nr.6 | 31 | 54 |

| | | |
|---|---|---|
| ¹⁾ Dose to print | | |

Angestrebt wird ein möglichst kleiner DTP-Wert, was eine hohe Lichtempfindlichkeit bedeutet, so dass nur eine geringe Belichtungsenergie erforderlich ist, sowie ein möglichst niedriger Dunkelabtrag. Der Dunkelabtrag gibt die beim Entwickeln in den nicht belichteten Bereichen abgelöste Schichtdicke an.

Es zeigt sich, dass nach dem erfindungsgemäßen Verfahren hergestellte Photoresists vergleichbar gute lithographische Eigenschaften zeigen, wie auf konventionellem Weg hergestellte Photoresists.

## Patentansprüche

1. Verfahren zur Herstellung einer lichtempfindlichen Photoresistlösung, **dadurch gekennzeichnet, dass** ein Novolakharz und ein Diazonaphthochinon-sulfochlorid in einem Lösemittel aus der Gruppe der Photoresistlösemittel gelöst werden, ein Anteil von 1 bis 70 Mol-% der phenolischen Hydroxygruppen des Novolakharzes mit dem Diazonaphthochinon-sulfochlorid in Gegenwart einer Base umgesetzt wird, das Reaktionsgemisch mit Wasser gewaschen und gegebenenfalls mit weiterem Photoresistlösemittel verdünnt wird.

2. Verfahren nach Anspruch 1, **dadurch gekennzeichnet, dass** das Novolakharz ein Molgewicht von mindestens 1.200 g/mol hat.

3. Verfahren nach Anspruch 1 oder 2, **dadurch gekennzeichnet, dass** ein Anteil von 1,5 bis 35 Mol-% der phenolischen Hydroxygruppen des Novolakharzes mit dem Diazonaphthochinon-sulfochlorid umgesetzt wird.

4. Verfahren nach mindestens einem der Ansprüche 1 bis 3, **dadurch gekennzeichnet, dass** ein Anteil von 2 bis 25 Mol-% der phenolischen Hydroxygruppen des Novolakharzes mit dem Diazonaphthochinon-sulfochlorid umgesetzt wird.

5. Verfahren nach mindestens einem der Ansprüche 1 bis 4, **dadurch gekennzeichnet, dass** das Diazonaphthochinon- Sulfochlorid 2,1-Diazonaphthochinon-4-sulfonsäurechlorid, 2,1-Diazonaphthochinon-5-sulfonsäurechlorid, 1,2-Diazonaphthochinon-6-sulfonsäurechlorid, 1,2-Diazonaphthochinon-7-sulfonsäurechlorid, 1,2-Diazonaphthochinon-8-sulfonsäurechlorid, 7-Methoxy-2,1-Diazonaphthochinon-5-sulfonsäurechlorid oder 7-Methoxy-2,1-Diazonaphthochinon-4-sulfonsäurechlorid ist.

6. Verfahren nach mindestens einem der Ansprüche 1 bis 5, **dadurch gekennzeichnet, dass** das Photoresistlösemittel 1,2-Propylenglykol-monomethylether, 1-Methoxy-2-propylacetat, Ethyllactat, 3-Methoxy-butylacetat, 1-Butoxy-2-propylacetat, Ethylacetat, Butylacetat, 2-Butanon, 2- oder 3-Pentanon, 3-Methyl-2-butanon, 4-Methyl-2-pentanon, 2-Heptanon, Methyl-Cellosolve, Ethyl-Cellosolve, Methyl-Cellosolveacetat, Ethyl-Cellosolveacetat, γ-Butyrolacton, Tetrahydrofuran, Tetrahydropyran, Dioxan und Cyclohexanon oder eine Kombination davon ist.

7. Verfahren nach Anspruch 6, **dadurch gekennzeichnet, dass** das Photoresistlösemittel 1-Methoxy-2-propylacetat, 3-Methoxy-butylacetat, 1-Butoxy-2-propylacetat, Ethylacetat, Butylacetat, 2- oder 3-Pentanon, 3-Methyl-2-butanon, 4-Methyl-2-pentanon, 2-Heptanon, und Cyclohexanon oder eine Kombination davon ist.

8. Verfahren nach Anspruch 7, **dadurch gekennzeichnet, dass** das Photoresistlösemittel 1-Methoxy-2-propylacetat, 3-Methoxy-butylacetat, 1-Butoxy-2-propylacetat, Butylacetat und 2-Heptanon oder eine Kombination davon ist.

9. Verfahren nach mindestens einem der Ansprüche 1 bis 8, **dadurch gekennzeichnet, dass** die Base ein tertiäres Amin, ein anorganisches Hydroxid oder Carbonat oder ein basischer Ionenaustauscher ist.

10. Verfahren nach mindestens einem der Ansprüche 1 bis 9, **dadurch gekennzeichnet, dass** die Umsetzung bei einer Temperatur zwischen -10°C und +60°C durchgeführt wird.

11. Verfahren nach mindestens einem der Ansprüche 1 bis 10, **dadurch gekennzeichnet, dass** der Lösemittelgehalt 55 bis 90 Gew.-%, bezogen auf das Gesamtgewicht der Lösung, beträgt.

12. Verfahren nach mindestens einem der Ansprüche 1 bis 11, **dadurch gekennzeichnet, dass** der umgesetzten Lösung Polyhydroxy-Benzophenone zugesetzt werden, deren OH-Gruppen frei sind oder mit Diazonaphthochinon-Gruppen verestert sind.

13. Verfahren nach mindestens einem der Ansprüche 1 bis 12 **dadurch gekennzeichnet, dass** der umgesetzten Lösung Novolak-Oligomere mit 2 bis 5 aromatischen Einheiten zugesetzt werden, deren phenolische OH-Gruppen frei sind oder mit Diazonaphthochinon-Gruppen verestert sind.

14. Verfahren nach mindestens einem der Ansprüche 1 bis 13 **dadurch gekennzeichnet, dass** der umgesetzten Lösung ein Novolak-Harz zugesetzt wird.

15. Verfahren zur strukturierten Beschichtung eines Substrats, wobei
a) ein Novolakharz und ein Diazonaphthochinon-sulfochlorid in einem Lösemittel aus der Gruppe der Photoresistlösemittel gelöst werden, ein Anteil von 1 bis 70 Mol-% der phenolischen Hydroxygruppen des Novolakharzes mit dem Diazonaphthochinon-sulfochlorid in Gegenwart einer Base umgesetzt wird, das Reaktionsgemisch mit Wasser gewaschen und gegebenenfalls mit weiterem Photoresistlösemittel verdünnt wird,
b) die so erhaltene Photoresistlösung direkt auf ein Substrat aufgebracht und vorgebacken wird,
c) der gebildete Photoresistfilm durch eine Photomaske belichtet wird,
d) der belichtete Photoresistfilm gebacken wird und
e) der gebackene, belichtete Photoresistfilm mit einem alkalischen Entwickler entwickelt wird.
